# EUROPÄISCHE PATENTSCHRIFT

(11) **EP 3 049 208 B1**
(45) Veröffentlichungstag und Bekanntmachung des Hinweises auf die Patenterteilung: **15.11.2017**
(21) Anmeldenummer: 14741534.3
(22) Anmeldetag: 30.06.2014
(51) Int. Cl.: B23K 1/08, B23K 3/06, H05K 3/34, B23K 3/08

(54) **LÖTDÜSENEINRICHTUNG ZUM SELEKTIVEN WELLENLÖTEN MIT EINER TRENNSTREIFENANORDNUNG**
SOLDERING NOZZLE DEVICE FOR SELECTIVE WAVE SOLDERING WITH A SEPARATING STRIP ARRANGEMENT
BUSE DE BRASAGE PERMETTANT UN BRASAGE SÉLECTIF À LA VAGUE AVEC UN ENSEMBLE DE BANDES DE SÉPARATION

(30) Priorität: 27.09.2013 DE 102013110731
(43) Veröffentlichungstag der Anmeldung: 03.08.2016
(73) Patentinhaber: Ersa GmbH, 97877 Wertheim (DE); Robert Bosch GmbH, 70469 Stuttgart (DE)
(72) Erfinder: SCHÜTZ, Steffen, 97892 Kreuzwertheim (DE); HAME, Simon, 97892 Kreuzwertheim (DE); HUHLER, Thomas, 97277 Böttigheim (DE)
(74) Vertreter: advotec.
(86) Internationale Anmeldenummer: PCT/EP2014/063844
(87) Internationale Veröffentlichungsnummer: WO 2015/043780

(56) Entgegenhaltungen:
- WO-A1-97/10393
- JP-A- 2000 223 827
- JP-A- 2001 219 295
- US-A1- 2002 162 879

## Beschreibung

Die Erfindung betrifft eine Anordnung aus zumindest zwei Trennstreifen für eine Lötdüse zum selektiven Wellenlöten gemäß dem Oberbegriff von Patentanspruch 1 (siehe z.B. US2002/0162879 A1). Es ist bekannt, bei der Herstellung bestückter Leiterplatten die auf der Leiterplatte angeordneten Bauteile durch selektives Wellenlöten mit der Leiterplatte zu verbinden.

Bei Anlagen zum selektiven Wellenlöten werden häufig mehrere Lötdüsen beispielsweise auf einer Düsenplatte so angeordnet, dass die Austrittsöffnungen der Lötdüsen in der Lötposition im Wesentlichen vertikal nach oben weisen. Dabei ist der Querschnitt jeder Lötdüse Lötbereichspezifisch geformt, und jede Lötdüse ist einem bestimmten zu lötenden Bereich der Platine zugeordnet. Zum Löten wird die Lötdüse bzw. die Düsenplatte mit den darauf angeordneten Lötdüsen von unten an die zu lötende Platine herangefahren. Dabei wird gleichzeitig der Innenraum der Lötdüse von unten mit flüssigem Lot durchströmt, welches an der in Lötposition obenliegenden Düsenöffnung austritt und die dort positionierten Lötstellen der Platine so benetzt, dass die gewünschte Lötverbindung zwischen dem zu verlötenden Bauteil - bzw. zwischen dem Draht-überstand des Bauteils - und dem zugehörigen Bereich der Platinen-Leiterbahn hergestellt wird.

Einer exakten Kontrolle aller Prozessparameter, wie beispielsweise Temperaturen, Lotdurchflussmengen, Abständen, Vorschubgeschwindigkeiten usw. kommt beim selektiven Wellenlöten, bzw. beim Multi-Wellenlöten mit mehreren Lötdüsen, eine hohe Bedeutung zu, um mit hoher Reproduzierbarkeit qualitativ hochwertige Lötstellen zu erhalten. Eine zentrale Anforderung beim Wellenlöten liegt ferner darin, dass zwischen benachbarten Lötstellen keine unerwünschte Lötbrücken beispielsweise durch verschlepptes oder überschüssiges Lot, bzw. durch unerwünscht zurückbleibende Lötperlen entstehen dürfen.

Um das hierzu erforderliche definierte rechtzeitige Abreißen des Lotstroms nach der jeweiligen Benetzung bzw. Verlötung einer Lötstelle oder einer Reihe aus Lötstellen zu gewährleisten, ist es bekannt, im Bereich der Lötwelle bzw. Lötdüse beispielsweise metallische Streifen aus mit Lot benetzbarem Material anzuordnen. Diese Metallstreifen werden während des Lötvorgangs in unmittelbare Nähe der Lötstelle bzw. einer Reihe aus Lötstellen bewegt. Im Verlauf der Lötung bildet sich eine Verbindung aus flüssigem Lot zwischen der Lötstelle und dem Metallstreifen. Auf diese Weise soll überschüssiges Lot von der Platine bzw. von den Lötstellen weggeführt werden, um damit die Entstehung unerwünschter Lötbrücken zwischen benachbarten Lötstellen oder benachbarten Reihen aus Lötstellen zu verhindern.

Die technische Entwicklung führt zu immer kleineren Bauteilen, Bauteilabständen und ebenso zu einem immer kleineren Pitch zwischen benachbarten Kontakten oder benachbarten Beinchen von einzulötenden Bauteilen. Die bekannten Ansätze zur Wegführung überschüssigen Lots von der Lötstelle und zur Unterbindung von Lötbrücken stoßen insbesondere bei diesen immer kleineren Pitch- und Bauteilabständen zunehmend an Grenzen. Insbesondere entsteht das Problem, dass bei sehr kleinem Pitch die bekannten Metallstreifen zur Wegführung überschüssigen Lots nicht mehr reproduzierbar mit ausreichender Genauigkeit an die jeweiligen Lötstellen bzw. Lötstellen-Reihen herangeführt werden können. Ebenso bereitet die Montage bzw. Befestigung der Metallstreifen an bzw. in der Lötdüse mit abnehmendem Pitch zunehmende Schwierigkeiten insbesondere dann, wenn eine Mehrzahl oder Vielzahl an Metallstreifen mit der Lötdüse verbunden werden soll. Multipliziert werden diese Probleme dadurch, dass Lötdüsen und insbesondere Metallstreifen zur Wegführung überschüssigen Lots regelmäßig gereinigt, gewartet bzw. ersetzt werden müssen, wodurch sich der vorgenannte Aufwand zur Re-Positionierung und Fixierung insbesondere der Metallstreifen entsprechend vervielfacht. Mit diesem Hintergrund liegt der Erfindung die Aufgabe zugrunde, die vorstehend beschriebenen Probleme und Beschränkungen bei der Wegführung von überschüssigem Lot und bei der Unterbindung von Lotbrücken beim selektiven Wellenlöten zu überwinden. Insbesondere soll es auch bei feinem Pitch bzw. bei eng benachbarten Lötstellen-Reihen möglich werden, überschüssiges Lot zuverlässig und reproduzierbar von den Lötstellen wegzuführen. Ferner soll die Handhabung, Wartung und Reinigung der Lötdüsen sowie der Einrichtung zur Wegführung überschüssigen Lots maßgeblich vereinfacht werden.

Diese Aufgabe wird durch eine Lötdüseneinrichtung nach der Lehre des Patentanspruchs 1 gelöst. Vorteilhafte Ausgestaltungen der Erfindung sind Gegenstand der Unteransprüche.

Die Trennstreifen sind in zunächst bekannter Weise einer Lötdüse in einer Lötanlage zugeordnet, wobei die Lötdüse zum gleichzeitigen selektiven Wellenlöten zumindest zweier beabstandet angeordneter Reihen von Lötstellen eingerichtet ist.

Erfindungsgemäß zeichnet sich die Trennstreifenanordnung dadurch aus, dass die Tiefenabmessung der Trennstreifen entlang der Lotzuflussrichtung zumindest ein Mehrfaches der Dickenabmessung der Trennstreifen beträgt, wobei die zumindest zwei Trennstreifen der Trennstreifenanordnung zudem als Trennstreifen-Schar zueinander exakt parallel ausgerichtet und zu einem Streifenpaket verbunden sind.

Die Erfindung liegt zunächst einmal die Erkenntnis der Anmelderinnen zugrunde, nach der eine reproduzierbare Wegführung überschüssigen Lots von einer Reihe aus Lötstellen dann gelingt, wenn die genannte Tiefenabmessung der Trennstreifen zumindest ein Mehrfaches, also ein mehr als Zweifaches, deren Dickenabmessung beträgt. Wie die Anmelderinnen erkannt haben, entsteht nur so eine ausreichende Oberflächenspannung des flüssigen Lots im Bereich der Trennstreifen, wodurch das flüssige Lot von der Lötstelle mittels Oberflächenspannung abgesaugt wird und auf den Trennstreifen überfließt. Bevorzugt weisen die Trennstreifen dabei eine Tiefenabmessung von 2 bis 12 mm, besonders bevorzugt von 4 bis 8 mm auf.

Um die eingangs beschriebenen Probleme bezüglich der Anordnung, Positionierung, Befestigung, Wartung und Reinigung der Trennstreifen zu lösen, sind die zumindest zwei Trennstreifen der Trennstreifenanordnung erfindungsgemäß zudem als Schar zueinander exakt parallel ausgerichtet und auf geeignete Weise gegenseitig fest miteinander zu einem Streifenpaket verbunden.

Durch die Verbindung der Trennstreifen zu einem Trennstreifen-Paket wird die Handhabung der Trennstreifen sowie insbesondere die Genauigkeit und Reproduzierbarkeit der Anordnung der Trennstreifen im Bereich der Düsenöffnung entscheidend verbessert. Die insbesondere bei feinem Bauteil-Pitch entscheidende, genaue Reproduzierbarkeit der Abstände zwischen den Trennstreifen sowie deren Toleranzen relativ zueinander, relativ zur Düsenöffnung sowie relativ zur Platine und zu den Lötstellen wird mit der Erfindung bei feinem Pitch in der Produktion überhaupt erst darstellbar.

Ferner erleichtert die Erfindung auch die Handhabung, die Robustheit, die Montage, Wartung und Demontage der Trennstreifen, da diese nicht mehr einzeln aufwändig gehandhabt, gewartet und montiert werden müssen. Vielmehr können alle diese Schritte dank der Erfindung anhand eines kompakten und robusten Pakets aus Trennstreifen stattfinden.

Auf diese Weise lassen sich Aufwand und Zeit zur Wartung und Reinigung der Lötdüse entscheidend verringern, die Lebens- bzw. Einsatzdauer der Trennstreifen wird erhöht, und Parallelität sowie Positioniergenauigkeit der Trennstreifen wird entscheidend verbessert. Ferner lässt sich die Befestigung bzw. Verankerung der Trennstreifen im Bereich der Düsenöffnung entscheidend vereinfachen, da dank der Erfindung nicht mehr einzelne empfindliche Trennstreifen, sondern ein kompaktes Streifenpaket gehandhabt und im Bereich der Düsenöffnung befestigt werden kann.

Zur Verwirklichung der Erfindung ist es zunächst einmal unerheblich, auf welche Weise die Trennstreifen exakt zueinander ausgerichtet und miteinander verbunden werden. So ist es gemäß einer möglichen Ausführungsform vorgesehen, die Trennstreifen beispielsweise miteinander zu vernieten oder zu verschrauben, wobei jeweils beispielsweise ringförmige Abstandshalter, die auf den Nieten oder Schrauben angeordnet werden, dafür sorgen, dass die Trennstreifen exakt parallel zueinander ausgerichtet sowie fest miteinander verbunden sind.

Gemäß hierzu alternativer sowie besonders bevorzugter Ausführungsformen der Erfindung sind die Trennstreifen zusammen mit zumindest einem die Trennstreifen verbindenden Steg, und/oder zusammen mit einem die Trennstreifen verbindenden, zumindest teilweise umlaufenden Rahmen, als einstückiges Streifenpaket ausgebildet.

Die dergestalt einstückige Ausbildung der Trennstreifen zusammen mit einem verbindenden Steg oder Rahmen führt zu einer besonders einfachen und kostengünstigen Herstellbarkeit der Streifenpakete, da zunächst einmal eine Montage aus einzelnen Trennstreifen, sowie Abstandshaltern und Verbindungselementen entfällt.

Auch gegen sich durch die einstückige Darstellung der Trennstreifenpakete weitere Verbesserungen bezüglich Einhaltung und Reproduzierbarkeit der Maße und Toleranzen des Streifenpakets, insbesondere bei feinem Pitch, Verbesserungen bezüglich der Ebenheit der Begrenzungsflächen des Streifenpakets, Verbesserungen bezüglich der Toleranzen zwischen dem Streifenpaket und dessen Aufnahme an bzw. in der Düsenöffnung, eine Verringerung der Gefahr des Verkantens oder Klemmens des Streifenpakets in der Düsenöffnung und einer damit verbundenen möglichen Beschädigung der Düsenöffnung. Ebenfalls erleichtert wird das Auswechseln, die Wartung und Reinigung des Streifenpakets, sowie nicht zuletzt die ggf. erforderliche Aktivierung, Verzinnung bzw. Benetzung der Trennstreifen-Oberflächen und damit auch die Wiederverwendbarkeit des Streifenpakets.

Das einstückige Streifenpaket wird vorzugsweise mittels Materialabtragung, beispielsweise durch Fräsen, aus einem massiven Metallblock gefertigt. Gemäß besonders bevorzugter Ausführungsformen der Erfindung erfolgt die Fertigung des einstückigen Streifenpakets aus einem massiven Metallblock durch Wasserstrahlschneiden, durch Drahterosion oder durch Laserschneiden. Dabei hat sich in Versuchen der Anmelderinnen gezeigt, dass das Wasserstrahlschneiden eine für die spätere Aktivierung, Verzinnung bzw. Lot-Benetzung der Oberfläche der Trennstreifen des Streifenpakets besonders vorteilhafte Oberflächentextur erzeugt.

Mit diesem Hintergrund ist es gemäß einer bevorzugten Ausführungsform der Erfindung ferner vorgesehen, dass das Streifenpaket aus Stahl, vorzugsweise aus Baustahl S235/ST37 besteht, und zumindest im Bereich der Trennstreifen mit Gold, Nickel-Gold und/oder Zinn beschichtet ist. Auch ein organischer Oberflächenschutz (OSP - Organic Surface Protection) kommt nach den Erkenntnissen der Anmelderinnen als Beschichtung für die Trennstreifen in Frage.

Es hat sich gezeigt, dass die genannten Materialkombinationen bzw. Beschichtungen vorteilhaft sind im Hinblick auf Lotbenetzung und das erforderliche Verhältnis der Oberflächenspannungen zwischen Lot und Trennstreifen , sowie gleichzeitig im Hinblick auf geringes Ablegieren und möglichst lange Standzeit des Streifenpakets, ohne Notwendigkeit zu zwischenzeitiger Wartung, Reinigung oder Erneuerung des Streifenpakets.

Die Art der Zuordnung des Streifenpakets zur Lötdüse bzw. die Befestigung des Streifenpakets an der Lötdüse ist erfindungsgemäß zunächst einmal beliebig, solange Streifenpaket und Lötdüse fest, jedoch lösbar miteinander verbindbar sind.

Gemäß bevorzugter Ausführungsformen der Erfindung ist das Streifenpaket in eine platinenseitige Düsenöffnung einsetzbar, oder auf eine platinenseitige Düsenöffnung aufsetzbar. Bei den letztgenannten Ausführungsformen kann das Streifenpaket beispielsweise selbst die Funktion der Düsenöffnung mit übernehmen. Beim Auswechseln des Streifenpakets, was zur Reinigung jeweils nach einigen Stunden Lötbetrieb, bzw. zur Erneuerung wegen Abnutzung jeweils nach einigen Wochen Anlagenbetrieb erforderlich werden kann, erhält die jeweilige Düse somit gleichzeitig auch eine neue bzw. gereinigte Düsenwandung und Düsenöffnung. Hierzu kann das Streifenpaket mit einem Rahmen aus anderem Material, insbesondere aus nicht mit Lot benetzbarem Material, wie beispielsweise Edelstahl, versehen sein, wobei der Rahmen in diesem Fall die Düsenwandung und Düsenöffnung bildet.

Bei der hierzu alternativen Ausführungsform mit in die Düsenöffnung einsetzbarem Streifenpaket ist es gemäß einer weiteren, bevorzugten Ausführungsform der Erfindung vorgesehen, dass zwischen dem zumindest teilweise umlaufenden Rahmen des Streifenpakets und einer lichten Öffnung der Lötdüse ein definierter, zumindest teilweise umlaufender Spalt angeordnet ist. Der Spalt hat dabei eine Weite in der Größenordnung von Zehntelmillimetern. Diese überhaupt erst dank der möglichen Herstellgenauigkeit des erfindungsgemäßen Streifenpakets ausführbare Ausführungsform hat den Vorteil, dass sich das Streifenpaket leicht und kräftefrei in die Düsenöffnung einsetzen bzw. aus der Lötdüse wieder entnehmen lässt, wodurch ein sehr schneller und damit wirtschaftlicher Wechsel des Streifenpakets im Betrieb der Lötanlage möglich wird.

Eine weitere bevorzugte Ausführungsform der Erfindung sieht vor, dass innerhalb der Öffnung der Lötdüse ein umlaufender Absatz angeordnet ist, auf dem der Boden des Streifenpakets zur Auflage gebracht werden kann. Auf diese Weise ergibt sich ein definierter Sitz des Streifenpakets auch in axialer Richtung der Lötdüse.

Gemäß einer weiteren Ausführungsform der Erfindung ist am düsenseitigen Boden des Streifenpakets ein Fortsatz, beispielsweise ein Bolzen angeordnet. Der Fortsatz kann zum Zweck der Fixierung des Streifenpakets entlang der axialen Richtung der Lötdüse, bzw. entlang der Lotflussrichtung mit einem quer zum Lotfluss durch die Düsenwandungen steckbaren Querbolzen, oder mit einer entsprechend angeordneten Schraube, in Eingriff gebracht werden. Auf diese Weise wird das Streifenpaket in der Düsenöffnung fixiert, und ein Herausspülen des Streifenpakets aus der Düsenöffnung durch die Pumpwirkung des Lotstroms wird unterbunden. Eine weitere Möglichkeit der Verbindung zwischen Streifenpaket und Lötdüse bzw. Düsenöffnung besteht im Einsatz einer Klemmeinrichtung, welche das Streifenpaket durch Klemmwirkung in der Düsenöffnung fixiert.

Gemäß hierzu alternativer Ausführungsformen ist das Streifenpaket mittels einer federnden Rasteinrichtung, oder magnetisch, entlang der Lotflussrichtung in der Düsenöffnung fixierbar. Im Fall der magnetischen Fixierung ist vorzugsweise am düsenseitigen Boden des Streifenpakets eine Magneteinrichtung angeordnet, beispielsweise ein Permanentmagnet. Falls das Streifenpaket aus Stahl oder ferromagnetischem Material besteht, kann das Material des Streifenpakets selbst die zur düsenseitigen Magneteinrichtung korrespondierende Magneteinrichtung bilden. Falls das Streifenpaket nicht aus Stahl oder ferromagnetischem Material besteht, kann am düsenseitigen Boden des Streifenpakets ebenfalls ein Permanentmagnet oder ein Element aus ferromagnetischem Material angeordnet sein. Die düsenseitigen und streifenpaketseitigen Magneteinrichtungen ziehen sich bei in die Düsenöffnung eingesetztem Streifenpaket gegenseitig an, und halten somit das Streifenpaket entgegen der Pumpwirkung des Lotstroms in der Düse fest.

Die Fixierung mittels einer federnden Rasteinrichtung oder mittels Permanentmagnet hat den Vorteil, konstruktiv einfacher zu sein als die Fixierung mittels Längs- und Querbolzen. Ferner haben die erstgenannten Ausführungsformen den Vorteil, dass das Streifenpaket in der Lötdüse fixiert und ebenso auch wieder entnommen werden kann, ohne dass die Düse hierzu seitlich zugänglich sein muss. Denn die Fixierung wird bei diesen Ausführungsformen bereits beim axialen Einfahren des Streifenpakets in die Düsenöffnung selbsttätig hergestellt, und löst sich ebenso durch einfaches Herausziehen des Streifenpakets, beispielsweise mit einem Zangenwerkzeug, in Düsenlängsrichtung. Auch entfällt eine Schwächung der Düsenwand aufgrund des Entfalls der für die Bolzenlösung notwendigen Querbohrungen durch die Düse, ebenso wie eine etwaige Beeinträchtigung des Lotrückflusses an der Außenseite der Düsenwandung entfällt.

Bei der Ausführungsform mit magnetischer Fixierung des Streifenpakets in der Düsenöffnung ist es bevorzugt vorgesehen, dass die Toleranzen des Vertikalanschlags in der Düsenöffnung, der Tiefenabmessung des Streifenpakets und der Positionen der Magneteinrichtungen entlang der Lotflussrichtung so gewählt sind, dass bei in die Düsenöffnung eingesetztem Streifenpaket ein Luftspalt zwischen dem Streifenpaket und der düsenseitigen Magneteinrichtung verbleibt. Auf diese Weise wird eine Überbestimmung des Sitzes des Streifenpakets in der Düse vermieden und damit ein spielfreier Sitz des Streifenpakets gewährleistet. Auch verringern sich hierdurch die Genauigkeitsanforderungen bezüglich der Herstellung und Anordnung des Vertikalanschlags, der Streifenpaket-Tiefenabmessung sowie der Magneteinrichtung, und damit auch entsprechend die Herstellungskosten.

Vorzugsweise umfasst die Magneteinrichtung dabei einen in einer Metallhülse aufgenommenen Permanentmagneten. Die Metallhülse ist in eine Aussparung des Düsenbodens der Lötdüse einsetzbar und dort, zur Befestigung der Magneteinrichtung am Düsenboden, in radialer Richtung duktil verfombar. Dies bedeutet, dass die Magneteinrichtung, ähnlich eines Blindniets, einfach und kostengünstig mit der Düse verbunden, und durch Austreiben oder Ausbohren auch wieder von der Düse trennbar ist.

Eine weitere bevorzugte Ausführungsform der Erfindung sieht vor, dass der zumindest teilweise umlaufende Rahmen des Streifenpakets, bzw. die Form der äußeren Begrenzung des Streifenpakets, ebenso wie die zugehörige Düsenöffnung, zumindest einen Eckbereich aufweist, dessen Form sich von der Form der anderen Eckbereiche unterscheidet, beispielsweise indem der zumindest eine Eckbereich einen Eckradius erhält, welcher sich vom Eckradius der anderen Eckbereiche wesentlich unterscheidet. Auf diese Weise wird ein fehlerhaftes Einsetzen des Streifenpakets in die Düsenöffnung verhindert.

Gemäß einer weiteren Ausführungsform der Erfindung weist die Wandung der Lötdüse im Bereich der Aufnahme für das Streifenpaket zumindest eine, vorzugsweise jedoch mindestens zwei Aussparungen auf, die zum Düsenende hin offen ist bzw. sind. Dies dient dem einfachen Auswechseln des Streifenpakets in der Form, dass das Streifenpaket - mittels Eingriff in die nach oben offenen Aussparungen mit einem oder mehreren Zangenwerkzeugen - somit einfach vertikal nach oben aus der Lötdüse herausgezogen werden kann.

Eine weitere bevorzugte Ausführungsform der Erfindung sieht vor, dass das Streifenpaket an seiner der Platine zugewandten Begrenzungsfläche eine zumindest teilweise umlaufende Randkante aufweist. Die Randkante ist so positioniert, dass sie bei korrekt in die Düse eingesetztem Streifenpaket bündig mit einer düsenseitigen Abschlusskante der Lötdüse abschließt. Auf diese Weise kann einfach überprüft werden, ob das Streifenpaket korrekt und vollständig in der Düsenöffnung sitzt.

Gemäß einer weiteren möglichen Ausführungsform der Erfindung weisen die zumindest zwei Trennstreifen unterschiedliche Tiefenabmessungen und/oder unterschiedliche Positionen entlang der axialen Düsenrichtung bzw. Lotflussrichtung auf. Auf diese Weise wird es möglich, das Streifenpaket optimal an etwaige vertikale Konturen der Platine, bzw. an unterschiedlich große Drahtüberstände der zu verlötenden Bauteile anzupassen.

Gemäß einer weiteren, besonders bevorzugten Ausführungsform der Erfindung ist ferner zumindest einer der Trennstreifen des Streifenpakets (vorzugsweise mehrere oder alle Trennstreifen eines Streifenpakets) jeweils einer Reihe von Lötstellen zugeordnet dergestalt, dass eine gedachte Längsmittelebene des Trennstreifens die Platine in den Mittelpunkten der Lötstellen schneidet. Auf diese Weise wird eine besonders wirksame Absaugung überschüssigen Lots von der jeweiligen Lötstellen-Reihe erreicht, indem das flüssige Lot beidseitig, jeweils entlang einer Oberfläche des Trennstreifens, aufgrund der Oberflächenspannung zwischen Lot und Trennstreifen-Oberfläche, abgesaugt wird.

Eine hierzu alternative Ausführungsform sieht vor, dass zumindest ein Trennstreifen, vorzugsweise mehrere oder alle Trennstreifen eines Streifenpakets, jeweils zwei Reihen von Lötstellen zugeordnet sind dergestalt, dass eine gedachte Längsmittelebene des jeweiligen Trennstreifens die Platine mittig zwischen den beiden Lötstellen-Reihen schneidet. Auf diese Weise wird überschüssiges Lot der jeweiligen Lötstellen-Reihe auf beiden Seiten von unterschiedlichen Trennstreifen aufgenommen und mittels Oberflächenspannung abgesaugt.

Weitere mögliche Ausführungsformen der Erfindung sehen vor, dass das Streifenpaket zumindest eine Schar aus diagonal verlaufenden Trennstreifen, oder eine gitterförmige Anordnung aus zumindest zwei sich gegenseitig kreuzenden Scharen aus jeweils parallel verlaufenden Trennstreifen umfasst. Auf diese Weise können auch besonders komplexe und/oder enge Anordnungen von Lötstellen wellengelötet werden, ohne dass unerwünschte Lötbrücken entstehen.

Im Folgenden wird die Erfindung anhand lediglich Ausführungsbeispiele darstellender Zeichnungen näher erläutert.

Dabei zeigt:
- Fig. 1: in isometrischer Darstellung eine Anordnung von Lötdü-sen zum selektiven Wellenlöten mit Trennstreifen-Paketen auf einer Düsenplatte;
- **Fig. 2**: in der Draufsicht eine Düsenanordnung vergleichbar der Düsenanordnung gemäß **Fig. 1****;**
- **Fig. 3**: in isometrischer Darstellung ein Streifenpaket;

- **Fig. 4**: das Streifenpaket gemäß **Fig. 3** in der Draufsicht;
- **Fig. 5**: in einer **Fig. 3** entsprechenden Darstellung und Ansicht ein Streifenpaket; und
- **Fig. 6**: das Streifenpaket gemäß **Fig. 5** in der Draufsicht.

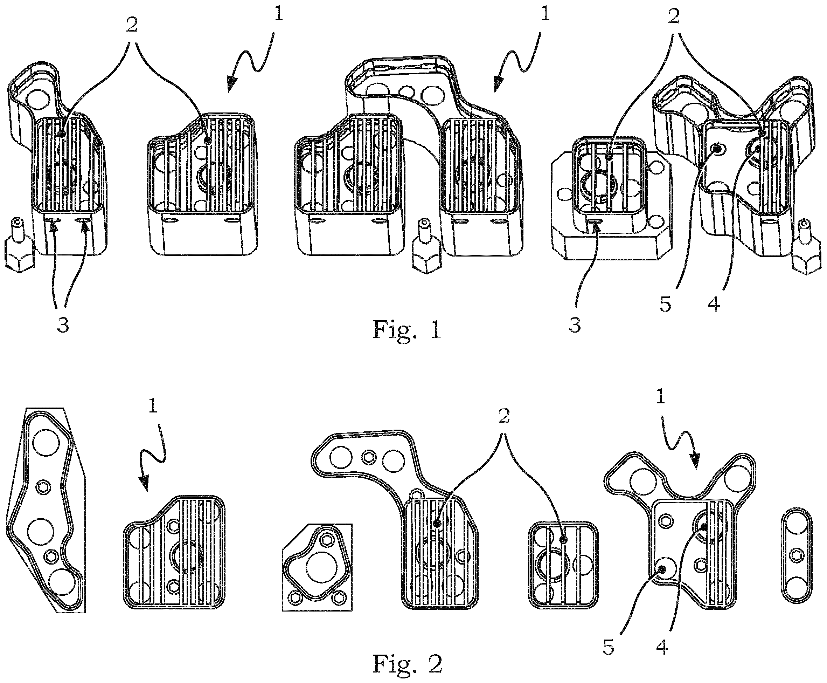

**Fig. 1** und **2** zeigen jeweils eine Düsenanordnung aus Lötdüsen 1, wie sie auf einer (nicht dargestellten) Düsenplatte einer Lötanlage zum selektiven Wellenlöten angeordnet werden können. Man erkennt eine Vielzahl unterschiedlicher Querschnittsformen der Lötdüsen 1. Anordnung und Querschnittsform der Lötdüsen 1 sind dabei jeweils produktspezifisch an zu lötende Bereiche auf einer (nicht dargestellten) Platine angepasst. In die meisten der dargestellten Lötdüsen 1 sind jeweils zumindest bereichsweise Trennstreifen-Pakete 2 eingesetzt. Die Streifenpakete 2 werden, gemäß der Erfindung, während des Lötvorgangs in unmittelbare Nähe der jeweiligen Lötstellen-Reihen auf den Platinen gebracht, so dass im Verlauf der Lötung überschüssiges Lot von den Lötstellen-Reihen auf die (mit Lotbenetzbarer Materialoberfläche versehenen) Trennstreifen der Streifenpakete 2 übergehen und damit von den Lötstellen bzw. Platinen abgeleitet kann, um so unerwünschte Lötperlen oder Lötbrücken auf den Platinen zu vermeiden.

Man erkennt ferner seitliche Düsen-Abflussöffnungen 3, durch welche überschüssiges Lot im Hinblick auf permanente Lot-Umwälzung und damit permanente Wärmezufuhr seitlich aus den Lötdüsen 1 abfließen kann. Ebenfalls sichtbar sind im Düsenboden angeordnete Magneteinrichtungen 4, welche die Streifenpakete 2 entgegen der Pumpwirkung des von unten durch Bohrungen 5 im Düsenboden strömenden Lotflusses in der Düsenöffnung fixieren.

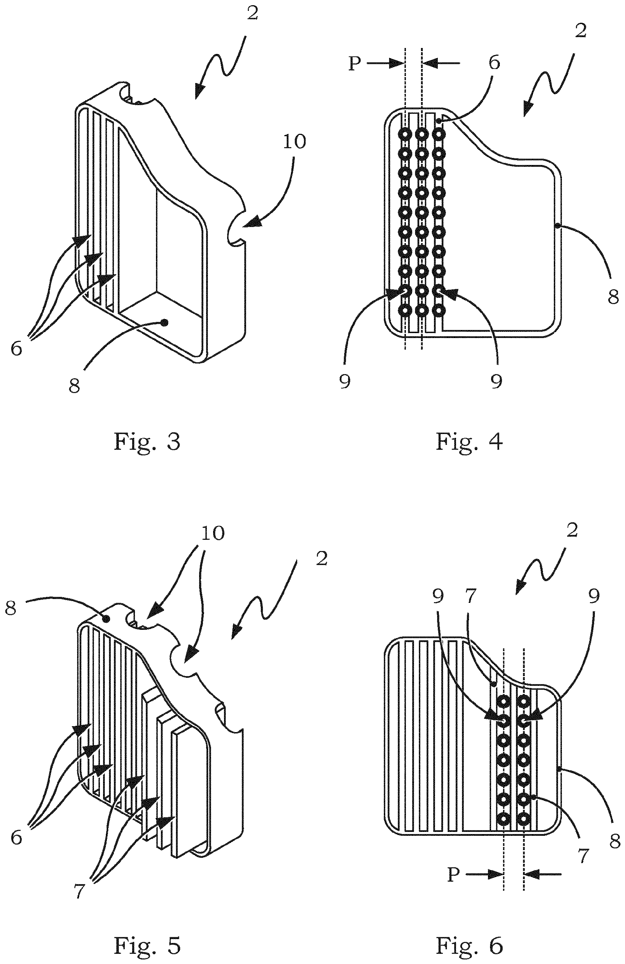

Fig. 3 bis 6 zeigen beispielhaft zwei Ausführungsformen der Streifenpakete 2, wie sie in einigen der Lötdüsen 1 gemäß **Fig**. **1** und 2 angeordnet sind. Man erkennt zunächst, dass die Streifenpakete 2 einstückig aus massivem Material hergestellt sind, vorzugsweise aus Stahl, und jeweils Scharen aus parallelen Trennstreifen 6, 7 sowie einen umlaufenden Rahmen 8 aufweisen.

Insbesondere bei besonders feinem Pitch P der zu lötenden Platinen (wie in **Fig. 4** und **6** anhand der Lötstellen-Reihen 9 angedeutet) bzw. bei entsprechend geringem Lötstellenabstand der Bauteile und Baugruppen auf der Platine, ermöglichen die als bevorzugt einstückige Pakete 2 ausgebildeten Trennstreifen-Anordnungen 6, 7 eine exakte Zuordnung zwischen den Trennstreifen 6, 7 und den jeweiligen Lötstellen-Reihen 9.

In den **Fig. 4** und **6** sind dabei zwei unterschiedliche Arten der Zuordnung bzw. relativen Positionierung zwischen den jeweiligen Trennstreifen-Scharen 6, 7 und den Lötstellen-Reihen 9 dargestellt. Bei der Ausführungsform gemäß Fig. 4 ist das Streifenpaket 2 relativ zur (nicht dargestellten) Platine so positioniert, dass jeweils ein Trennstreifen 6 einer Reihe aus Lötstellen 9 zugeordnet ist. Dies bedeutet, dass bei dieser Ausführungsform überschüssiges Lot an jeder der Lötstellen 9 jeweils von den beiden seitlichen Oberflächen desselben Trennstreifens 6 abgeleitet bzw. mittels Oberflächenspannung abgesaugt wird.

Bei der Fig. 6 hingegen ist das Streifenpaket 2 relativ zur Platine bzw. zu den Lötstellen 9 so positioniert, dass die Lötstellen-Reihen 9 jeweils zwischen zwei Trennstreifen 7 zu liegen kommen. Demzufolge wird überschüssiges Lot an jeder der Lötstellen 9 gemäß Fig. 6 von gegenüberliegenden Seitenoberflächen zweier verschiedener Trennstreifen 7 abgeleitet bzw. abgesaugt. Die Form gemäß Fig. 6 eignet sich dabei insbesondere bei größeren Draht-überständen der zu verlötenden Bauteile, da diese dann zwischen den Trennstreifen 6 zu liegen kommen und somit nicht mit den Trennstreifen 6 kollidieren.

Ferner wird auch die Handhabung der Trennstreifen 6, 7 in Form von Paketen 2 gegenüber der Montage einzelner Trennelemente in den Lötdüsen 1 maßgeblich vereinfacht, erleichtert und beschleunigt. Die Trennstreifen-Pakete 2 sind erheblich robuster und verbessern massiv die erforderliche Einhaltung der Maße und Toleranzen bezüglich Position und relativer Lage der Trennstreifen 6, 7 zueinander sowie zur Platine und zu den Lötstellen 9. Wartung, Wechsel und Reinigung der Trennstreifen 6, 7 werden dank deren Ausbildung als einstückige Streifenpakete 2 entscheidend erleichtert und beschleunigt, und die Lebensdauer der Trennstreifen 6, 7 wird zudem verlängert. Die einstückig hergestellten Streifenpakete 2 erfordern keine aufwändige Montage aus zahlreichen Einzelteilen, womit auch entsprechende Fehlerquellen wegfallen.

Das in **Fig. 5** und **6** dargestellte Streifenpaket 2 umfasst zwei Scharen 6, 7 aus Trennstreifen, die eine unterschiedliche Breite, sprich Tiefenabmessung bezogen auf den Lotstrom, aufweisen. Auf diese Weise können beispielsweise unterschiedliche vertikale Konturen auf der Platine, bzw. unterschiedlich große Drahtüberstände der zu verlötenden Bauteile berücksichtigt werden, und die Trennstreifen 6, 7 können im jeweils optimalen bzw. minimalen Abstand zu den jeweiligen Lötstellen-Reihen 9 positioniert werden.

Die in den **Fig. 3** und **5** erkennbaren Ausnehmungen 10 korrespondieren mit den Düsen-Abflussöffnungen 3 gemäß **Fig. 1****,** und ermöglichen somit im Hinblick auf permanente Lot-Umwälzung und Wärmezufuhr den ungestörten seitlichen Abfluss überschüssigen Lots.

### Bezugszeichenliste

- 1: Lötdüse
- 2: Streifenpaket, Trennstreifen-Paket
- 3: Überlaufbohrung
- 4: Magneteinrichtung
- 5: Lotfluss-Bohrung
- 6, 7: Trennstreifen, Trennstreifen-Schar
- 8: umlaufender Rahmen
- 9: Lötstelle
- 10: Ausnehmung

## Patentansprüche

1. Lötdüseneinrichtung mit Lötdüse (1) zum gleichzeitigen selektiven Wellenlöten zumindest zweier beabstandet angeordneter Reihen von Lötstellen (9) in einer Lötanlage, die Lötdüseneinrichtung umfassend ein mit der Lötdüse (1) verbindbares Streifenpaket (2), welches zumindest zwei mit Lot benetzbare Trennstreifen (6, 7) umfasst, wobei die zumindest zwei Trennstreifen (6, 7) zueinander sowie zu den Lötstellen-Reihen exakt parallel aus-gerichtet und als Trennstreifen-Schar (6, 7) fest zu einem Streifenpaket (2) verbunden sind,
**dadurch gekennzeichnet,**
**dass** die Trennstreifen (6, 7) während des Lötvorgangs in unmittelbare Nähe der Lötstellen-Reihen (9) bringbar sind, so dass im Verlauf der Lötung überschüssiges Lot von den Lötstellen auf die Trennstreifen (6, 7) der Streifenpakete (2) übergeht, und damit von den Lötstellen abgeleitet werden kann, um so unerwünschte Lötperlen oder Lötbrücken auf eine zu lötende Platine zu vermeiden, und dass die Tiefenabmessung der Trennstreifen (6, 7), zur Erzeugung ei-ner überschüssiges Lot von den Lötstellen (9) absaugenden Oberflächenspannung, entlang der Lotzuflussrichtung ein zumindest Mehrfaches der Dickenabmessung der Trennstreifen (6, 7) beträgt.

2. Lötdüseneinrichtung nach Anspruch 1,
**dadurch gekennzeichnet,**
**dass** die Trennstreifen (6, 7) eine Tiefenabmessung bevorzugt von 2 bis 12 mm, besonders bevorzugt von 4 bis 8 mm aufweisen.

3. Lötdüseneinrichtung nach Anspruch 1 oder 2,
**dadurch gekennzeichnet,**
**dass** die Trennstreifen (6, 7) unter Zwischenlage von Abstandshaltern miteinander zu einem Streifenpaket (2) verbunden, insbesondere vernietet oder verschraubt sind.

4. Lötdüseneinrichtung nach Anspruch 1 oder 2,
**dadurch gekennzeichnet,**
**dass** die Trennstreifen (6, 7) zusammen mit zumindest einem die Trennstreifen (6, 7) verbindenden Steg oder Rahmen als einstückiges Streifenpaket (2) ausgebildet sind.

5. Lötdüseneinrichtung nach Anspruch 4,
**dadurch gekennzeichnet,**
**dass** das Streifenpaket (2) mittels Materialabtragung, insbesondere Wasserstrahlschneiden, Drahterosion oder Laserschneiden aus einem massiven Metallblock gefertigt ist.

6. Lötdüseneinrichtung nach einem der Ansprüche 1 bis 5,
**dadurch gekennzeichnet,**
**dass** das Streifenpaket (2) aus Stahl besteht und zumindest im Bereich der Trennstreifen (6, 7) mit Gold, Nickel-Gold und/oder Zinn beschichtet ist.

7. Lötdüseneinrichtung nach einem der Ansprüche 1 bis 6,
**dadurch gekennzeichnet,**
**dass** innerhalb der Öffnung der Lötdüse (1) sowie am düsenseitigen Boden des Streifenpakets (2) miteinander korrespondierende Magneteinrichtungen (4) zur Fixierung des Streifenpakets (2) entlang der Lotflussrichtung angeordnet sind.

8. Lötdüseneinrichtung nach Anspruch 7,
**dadurch gekennzeichnet,**
**dass** die Toleranzen des Vertikalanschlags, der Tiefenabmessung des Streifenpakets (2) und der Vertikalpositionen der Magneteinrichtungen (4) so gewählt sind, dass bei in die Düsenöffnung eingesetztem Streifenpaket (2) ein Luftspalt zwischen den Magneteinrichtungen (4) verbleibt.

9. Lötdüseneinrichtung nach Anspruch 7 oder 8,
**dadurch gekennzeichnet,**
**dass** die düsenseitige Magneteinrichtung (4) einen in einer Metallhülse aufgenommenen Permanentmagneten umfasst, wobei die Metallhülse in eine Aussparung des Düsenbodens einsetzbar und zur Befestigung der Magneteinrichtung (4) in der Aussparung in radialer Richtung duktil verformbar ist.

10. Lötdüseneinrichtung nach einem der Ansprüche 1 bis 9,
**dadurch gekennzeichnet,**
**dass** das Streifenpaket (2) an seiner der Platine zugewandten Begrenzungsfläche eine zumindest teilweise umlaufende Randkante aufweist, die bei in die Düse eingesetztem Streifenpaket (2) bündig mit einer düsenseitigen Abschlusskante der Lötdüse (1) abschließt.

11. Lötdüseneinrichtung nach einem der Ansprüche 1 bis 10,
**dadurch gekennzeichnet,**
**dass** die zumindest zwei Trennstreifen (6, 7) unterschiedliche Tiefenabmessungen und/oder unterschiedliche axiale Positionen bezüglich der Lötdüse (1) aufweisen.

12. Lötdüseneinrichtung nach einem der Ansprüche 1 bis 11,
**dadurch gekennzeichnet,**
**dass** zumindest ein Trennstreifen (6) einer Reihe von Lötstellen (9) zugeordnet ist dergestalt, dass eine gedachte Längsmittelebene des Trennstreifens (6) die Platine in den Mittelpunkten der Lötstellen (9) schneidet.

13. Lötdüseneinrichtung nach einem der Ansprüche 1 bis 12,
**dadurch gekennzeichnet,**
**dass** zumindest ein Trennstreifen (7) zwei Reihen von Lötstellen (9) zugeordnet ist dergestalt, dass eine gedachte Längsmittelebene des Trennstreifens (7) die Platine mittig zwischen den beiden Lötstellen-Reihen (9) schneidet.

14. Lötdüseneinrichtung nach einem der Ansprüche 1 bis 13,
**dadurch gekennzeichnet,**
**dass** das Streifenpaket (2) zumindest eine Schar aus diagonal verlaufenden Trennstreifen (6, 7) umfasst.

15. Lötdüseneinrichtung nach einem der Ansprüche 1 bis 14,
**dadurch gekennzeichnet,**
**dass** das Streifenpaket (2) eine gitterförmige Anordnung aus zumindest zwei sich gegenseitig kreuzenden Scharen aus jeweils parallel verlaufenden Trennstreifen (6, 7) umfasst.

## Claims

1. A soldering nozzle device having a soldering nozzle (1) for simultaneous selective wave soldering of at least two rows of soldering points (9), said rows being arranged so as to be spaced apart, in a soldering installation, the soldering nozzle device comprising a strip assembly (2) connectable to the soldering nozzle (1), which comprises at least two solder-wettable separating strips (6, 7), the at least two separating strips (6, 7) being oriented exactly parallel both to one another and to the soldering point rows and are connected fixedly as a group of separating strips (6, 7) to form a strip assembly (2),
**characterized in that**
the separating strips (6, 7), during the soldering process, can be moved in close proximity to the soldering point rows (9) such that in the course of soldering excess solder is transferred from the soldering points to the separating strips (6, 7) of the strip assemblies (2) and can thus be diverted from the soldering points in order to thus avoid undesired solder beads or solder bridges on a circuit board which is to be soldered,
and **in that** the depth of the separating strips (6, 7), for generating a surface tension for suctioning off excess solder from the soldering points (9), along the solder influx direction, amounts to at least a multiple of the thickness of the separating strips (6, 7).

2. The soldering nozzle device according to claim 1,
**characterized in that**
the separating strips (6, 7) have a depth of preferably 2 to 12 mm, particularly preferably of 4 to 8 mm.

3. The soldering nozzle device according to claim 1 or 2,
**characterized in that**
the separating strips (6, 7) are connected to one another, in particular riveted or screwed together, to form a strip assembly (2), spacers being interposed.

4. The soldering nozzle device according to claim 1 or 2,
**characterized in that**
the separating strips (6, 7), together with at least one bridge or frame connecting the separating strips (6, 7), are embodied as a one-piece strip assembly (2).

5. The soldering nozzle device according to claim 4,
**characterized in that**
the strip assembly (2) has been manufactured from a solid metal block by removal of material, in particular by water jet cutting, by wire-electro discharge machining or by laser beam cutting.

6. The soldering nozzle device according to one of claims 1 to 5,
**characterized in that**
the strip assembly (2) consists of steel and is coated with gold, nickel gold and/or tin, at least in the area of the separating strips (6, 7).

7. The soldering nozzle device according to one of claims 1 to 6,
**characterized in that**
magnetic devices (4) corresponding to one another for fixing the strip assembly (2) along the solder flow direction are arranged within the opening of the soldering nozzle (1) and at the nozzle-sided bottom of the strip assembly (2).

8. The soldering nozzle device according to claim 7,
**characterized in that**
the tolerances of the vertical stop, of the depth of the strip assembly (2) and of the vertical positions of the magnetic devices (4) are chosen so as to keep an air gap between the magnetic devices (4) when the strip assembly (2) is in a state inserted into the nozzle opening.

9. The soldering nozzle device according to claim 7 or 8,
**characterized in that**
the nozzle-sided magnetic device (4) comprises a permanent magnet received in a metal sleeve, wherein the metal sleeve can be inserted into a recess of the nozzle bottom and can be radially deformed in a ductile fashion for fastening the magnetic device (4) in the recess.

10. The soldering nozzle device according to one of claims 1 to 9,
**characterized in that**
the strip assembly (2), at its boundary surface facing the circuit board, features an outer edge which is at least partially circumferential, and which is flush with a nozzle-sided terminal edge of the soldering nozzle (1) when the strip assembly (2) is in a state inserted into the nozzle.

11. The soldering nozzle device according to one of claims 1 to 10,
**characterized in that**
the at least two separating strips (6, 7) feature different depths and/or different axial positions relating to the soldering nozzle (1).

12. The soldering nozzle device according to one of claims 1 to 11,
**characterized in that**
at least one separating strip (6) is assigned to a row of soldering points (9), in such a way that a virtual longitudinal centre plane of the separating strip (6) intersects the circuit board in the centres of the soldering points (9).

13. The soldering nozzle device according to one of claims 1 to 12,
**characterized in that**
at least one separating strip (7) is assigned to two rows of soldering points (9), in such a way that a virtual longitudinal centre plane of the separating strip (7) centrally intersects the circuit board between the two soldering point rows (9).

14. The soldering nozzle device according to one of claims 1 to 13,
**characterized in that**
the strip assembly (2) comprises at least one group of separating strips (6, 7) arranged diagonally.

15. The soldering nozzle device according to one of claims 1 to 14,
**characterized in that**
the strip assembly (2) comprises a grid-shaped arrangement of at least two criss-crossing groups of separating strips (6, 7) running in parallel in each instance.

## Revendications

1. Dispositif de buse de brasage ayant une buse (01) de brasage pour permettre un brasage à la vague sélectif simultané d'au moins deux points (9) de brasage disposés de manière espacée les uns des autres dans une installation de brasage, ledit dispositif de buse de brasage comprenant un ensemble (2) de bandes, qui peut être relié à la buse (1) de brasage et comprend au moins deux bandes (6, 7) de séparation mouillables par une brasure, lesdites au moins deux bandes (6, 7) de séparation étant orientées exactement parallèlement les unes aux autres ainsi que parallèlement aux rangées de points de brasage et étant reliées solidement entre elles en tant que groupe (6, 7) de bandes de séparation pour former un ensemble (2) de bandes,
**caractérisé en ce que**
les bandes (6, 7) de séparation peuvent être amenées dans la proximité immédiate des rangées de points (9) de brasage pendant le procédé de brasage de sorte que de la brasure excédentaire passe des points de brasage sur les bandes (6, 7) de séparation des ensembles (2) de bandes au cours du brasage et peut donc être évacuée des points de brasage afin d'éviter des gouttes de brasage ou des ponts de brasage indésirables sur une platine à être brasée,
et **en ce que** la cote de profondeur des bandes (6, 7) de séparation est au moins un multiple de la cote d'épaisseur des bandes (6, 7) de séparation le long de la direction d'afflux de brasure pour produire une tension superficielle aspirant la brasure excédentaire des points (9) de brasage.

2. Dispositif de buse de brasage selon la revendication 1,
**caractérisé en ce que**
les bandes (6, 7) de séparation ont une cote de profondeur de préférence allant de 2 à 12 mm, de manière particulièrement préférée allant de 4 à 8 mm.

3. Dispositif de buse de brasage selon la revendication 1 ou 2,
**caractérisé en ce que**
les bandes (6, 7) de séparation sont reliées, notamment rivetées ou vissées, les unes aux autres avec des entretoises intercalées afin de former un ensemble (2) de bandes.

4. Dispositif de buse de brasage selon la revendication 1 ou 2,
**caractérisé en ce que**
les bandes (6, 7) de séparation sont formées en tant qu'ensemble (2) de bandes d'un seul tenant avec au moins une traverse ou un cadre reliant les bandes (6, 7) de séparation.

5. Dispositif de buse de brasage selon la revendication 4,
**caractérisé en ce que**
l'ensemble (2) de bandes est produit d'un bloc de métal solide au moyen d'un enlèvement de matière, notamment par découpe par jet d'eau, par électroérosion à fil ou par découpe laser.

6. Dispositif de buse de brasage selon l'une quelconque des revendications 1 à 5,
**caractérisé en ce que**
l'ensemble (2) de bandes est en acier et est revêtu d'or, de nickel-or et/ou d'étain au moins dans la zone des bandes (6, 7) de séparation.

7. Dispositif de buse de brasage selon l'une quelconque des revendications 1 à 6,
**caractérisé en ce que**
des dispositifs (4) d'aimant correspondant les uns aux autres sont disposés dans l'ouverture de la buse (1) de brasage ainsi que sur le fond de l'ensemble (2) de bandes situé du côté de la buse pour fixer l'ensemble (2) de bandes le long de la direction d'afflux de brasure.

8. Dispositif de buse de brasage selon la revendication 7,
**caractérisé en ce que**
les tolérances de la butée verticale, de la cote de profondeur de l'ensemble (2) de bandes et des positions verticales des dispositifs (4) d'aimant sont choisies de manière qu'un entrefer reste entre les dispositifs (4) d'aimant quand l'ensemble (2) de bandes est inséré dans l'ouverture de buse.

9. Dispositif de buse de brasage selon la revendication 7 ou 8,
**caractérisé en ce que**
le dispositif (4) d'aimant disposé du côté de la buse comprend un aimant permanent reçu dans une douille métallique, ladite douille métallique pouvant être insérée dans un évidement du fond de buse et pouvant être déformée de manière ductile dans la direction radiale pour fixer le dispositif (4) d'aimant dans l'évidement.

10. Dispositif de buse de brasage selon l'une quelconque des revendications 1 à 9,
**caractérisé en ce que**
l'ensemble (2) de bandes comprend au moins un bord extérieur au moins partiellement périphérique à sa surface de délimitation tournée vers la platine, ledit bord extérieur se terminant en affleurement avec un bord terminal de la buse (1) de brasage disposé du côté de la buse quand la buse est insérée dans l'ensemble (2) de bandes.

11. Dispositif de buse de brasage selon l'une quelconque des revendications 1 à 10,
**caractérisé en ce que**
lesdites au moins deux bandes (6, 7) de séparation ont des cotes de profondeur différentes et/ou des positions axiales différentes par rapport à la buse (1) de brasage.

12. Dispositif de buse de brasage selon l'une quelconque des revendications 1 à 11,
**caractérisé en ce qu'**
au moins une bande (6) de séparation est attribuée à une rangée de points (9) de brasage de telle manière qu'un plan central longitudinal imaginé de la bande (6) de séparation intersecte la platine au centre des points (9) de brasage.

13. Dispositif de buse de brasage selon l'une quelconque des revendications 1 à 12,
**caractérisé en ce qu'**
au moins une bande (7) de séparation est attribuée à deux rangées de points (9) de brasage de telle manière qu'un plan central longitudinal imaginé de la bande (7) de séparation intersecte la platine au milieu entre les deux rangées de points (9) de brasage.

14. Dispositif de buse de brasage selon l'une quelconque des revendications 1 à 13,
**caractérisé en ce que**
l'ensemble (2) de bandes comprend au moins un groupe de bandes (6, 7) de séparation s'étendant diagonalement.

15. Dispositif de buse de brasage selon l'une quelconque des revendications 1 à 14,
**caractérisé en ce que**
l'ensemble (2) de bandes comprend un ensemble en forme de grille d'au moins deux groupes de bandes (6, 7) de séparation s'étendant parallèlement à chaque fois, lesdits groupes se croisant.
